# EUROPÄISCHE PATENTANMELDUNG

(11) **EP 4 432 491 A1**
(43) Veröffentlichungstag der Anmeldung: **18.09.2024**
(21) Anmeldenummer: 24163556.4
(22) Anmeldetag: 14.03.2024
(51) Int. Cl.: H01S 5/22, H01S 5/02, H01S 5/34, H01S 5/20, H01S 5/227

(54) **QUANTENKASKADENLASER UND VERFAHREN ZU SEINER HERSTELLUNG**

(30) Priorität: 15.03.2023 DE 102023106427
(71) Anmelder: Fraunhofer-Gesellschaft zur Förderung der angewandten Forschung e.V., 80686 München (DE)
(72) Erfinder: Driad, Rachid, 79108 Freiburg (DE); Bächle, Andreas, 79108 Freiburg (DE)
(74) Vertreter: Friese Goeden Patentanwälte PartGmbB

(57) **Zusammenfassung**

Die Erfindung betrifft einen Quantenkaskadenlaser (1) mit einem Substrat (10) mit einer ersten Seite (101) und einer gegenüberliegenden zweiten Seite (102) und mit einem aktiven Bereich (2) mit einer ersten Seite (201) und einer gegenüberliegenden zweiten Seite (202), wobei die zweite Seite (202) des aktiven Bereichs (2) auf der ersten Seite (101) des Substrats (10) angeordnet ist und der aktive Bereich (2) Seitenflächen (205) aufweist, welche sich von der ersten Seite (201) des aktiven Bereichs (2) zur zweiten Seite (202) des aktiven Bereichs (2) erstrecken und mit zumindest einer Isolatorschicht (40) mit einer ersten Seite (401) und einer gegenüberliegenden zweiten Seite (402), wobei die zweite Seite (402) der Isolatorschicht (40) auf der ersten Seite (101) des Substrats (10) angeordnet ist und sich die Isolatorschicht (40) bis zu den Seitenflächen (205) des aktiven Bereichs (2) erstreckt und dicker ist als der aktive Bereich (2) und die erste Seite (201) des aktiven Bereichs (2) nicht bedeckt, wobei in die erste Seite (101) des Substrats (10) angrenzend an die zweite Seite (202) des aktiven Bereichs (2) eine Stufe (15) eingebracht ist, wobei die Seitenfläche (155) der Stufe (15) mit der ersten Seite (101) des Substrats (10) einen Winkel von 85° bis 95° einschließt und wobeieine Seitenfläche (155) der Stufe (15) mit einer [011]- Orientierung erzeugt wird und/oder eine Seitenfläche (155) der Stufe (15) mit einer [011]- Orientierung erzeugt wird. Weiterhin betrifft die Erfindung ein Verfahren zur Herstellung eines solchen Quantenkaskadenlasers.

## Beschreibung

Die Erfindung betrifft einen Quantenkaskadenlaser mit einem Substrat mit einer ersten Seite und einer gegenüberliegenden zweiten Seite und mit einem aktiven Bereich mit einer ersten Seite und einer gegenüberliegenden zweiten Seite, wobei die zweite Seite des aktiven Bereichs auf der ersten Seite des Substrats angeordnet ist und der aktive Bereich Seitenflächen aufweist, welche sich von der ersten Seite des aktiven Bereichs zur zweiten Seite des aktiven Bereichs erstrecken, und mit zumindest einer Isolatorschicht mit einer ersten Seite und einer gegenüberliegenden zweiten Seite, wobei die zweite Seite der Isolatorschicht auf der ersten Seite des Substrats angeordnet und dicker ist als der aktive Bereich (2) und die erste Seite (201) des aktiven Bereichs (2) nicht bedeckt. Weiterhin betrifft die Erfindung ein Verfahren zur Herstellung eines solchen Quantenkaskadenlasers. Quantenkaskadenlaser dieser Art emittieren elektromagnetische Strahlung im mittleren und fernen Infrarot und können beispielsweise zur Spektroskopie oder zur Spurengasanalyse eingesetzt werden.

Aus der US 2013/0017638 A1 ist ein Quantenkaskadenlaser und ein Verfahren zu seiner Herstellung bekannt. Zur Herstellung eines solchen Quantenkaskadenlasers wird eine Halbleiterheterostruktur auf einem Substrat erzeugt. Die Halbleiterheterostruktur enthält eine Mehrzahl dünner Schichten aus unterschiedlichen Halbleitermaterialien, wie beispielsweise InGaAs und AlInAs. Nach Aufbringen und Strukturieren einer Maskierungsschicht werden einzelne Rippen aus der Halbleiterheterostruktur als aktives Medium durch nass- oder trockenchemisches Ätzen freigestellt. Die solchermaßen vereinzelten Quantenkaskadenlaser werden mit einer Isolatorschicht überwachsen, sodass das aktive Medium vollständig in der Isolatorschicht eingebettet ist.

Dieser bekannte Quantenkaskadenlaser weist jedoch den Nachteil auf, dass sich unter der Maskierungsschicht Hinterschneidungen bilden, welche beim nachträglichen Überwachsen mit der Isolatorschicht unvollständig ausgefüllt werden. Darüber hinaus kann die Kristallqualität der Isolatorschicht an der Grenzfläche zum aktiven Medium unzureichend sein, sodass Ladungsträger aus dem aktiven Medium abfließen oder Nicht-Gleichgewichtsladungsträger an tiefen Störstellen rekombinieren können. Hierdurch wird die Ausgangsleistung des Quantenkaskadenlasers reduziert.

Ausgehend vom Stand der Technik liegt der Erfindung somit die Aufgabe zugrunde, einen Quantenkaskadenlaser mit besserer Leistung bereitzustellen.

Gemäß der nachfolgenden Beschreibung wird ein Quantenkaskadenlaser und ein Verfahren zu seiner Herstellung vorgeschlagen. Zur Herstellung kann ein Substrat bereitgestellt werden, welches eine erste Seite und eine gegenüberliegende zweiten Seite aufweist. Das Substrat kann in einigen Ausführungsformen GaAs und/oder GaN und/oder AlN und/oder InP und/oder Si und/oder SiC und/oder Saphir enthalten oder daraus bestehen. Das Substrat kann eine Dicke von etwa 350 pm bis etwa 500 pm oder von etwa 500 pm bis etwa 750 pm oder von etwa 100 pm bis etwa 250 pm oder von etwa 50 pm bis etwa 250 pm aufweisen. Das Substrat kann homogen aufgebaut sein oder mit einer oder mehreren Beschichtungen versehen sein. Das Substrat kann in einigen Ausführungsformen der Erfindung einen Durchmesser von etwa 2 Zoll oder von etwa 3 Zoll oder von etwa 4 Zoll oder von etwa 6 Zoll aufweisen. In einigen Ausführungsformen der Erfindung kann das Substrat ein Einkristall sein bzw. ein kristallines Material enthalten.

In einigen Ausführungsformen der Erfindung kann das Substrat eine erste Seite aufweisen, welche eine [100]-Orientierung aufweist. Für die Zwecke der vorliegenden Erfindung werden Orientierungen mit Millerschen Indices angegeben.

In einigen Ausführungsformen der Erfindung kann das Substrat eine oder mehrere Beschichtungen aufweisen, welche beispielsweise als Ätzstoppschicht verwendet werden oder eine Gitterfehlanpassung zu nachfolgenden Schichten reduzieren können. Hierdurch kann die Herstellung des erfindungsgemäßen Quantenkaskadenlasers vereinfacht sein.

In einigen Ausführungsformen der Erfindung kann auf dieses Substrat eine Mehrzahl von Schichten aus zumindest einem Halbleitermaterial abgeschieden werden. Die Schichten können dazu vorgesehen sein, zumindest den aktiven Bereich des Quantenkaskadenlasers zu bilden. Die Schichten können jeweils eine binäre, ternäre, quaternäre oder quinäre Verbindung aus einem III-V-Halbleiter enthalten oder daraus bestehen. In einigen Ausführungsformen der Erfindung können die Schichten eine unterschiedliche Bandlückenenergie aufweisen, sodass die Mehrzahl dieser Schichten ein Übergitter und/oder eine Quantentopfstruktur bilden. In einigen Ausführungsformen der Erfindung kann der aktive Bereich eine Abfolge von Schichten enthalten, welche jeweils entweder InAlAs oder InGaAs enthalten oder daraus bestehen. In anderen Ausführungsformen der Erfindung kann der aktive Bereich eine Abfolge von Schichten enthalten, welche jeweils entweder AlAs oder InAs enthalten oder daraus bestehen. Die Mehrzahl von Schichten kann mittels MBE und/oder MOMBE und/oder GSMBE und/oder MOCVD bzw. MOVPE auf dem Substrat abgeschieden werden. Die Schichten können eine Teilfläche des Substrates bedecken oder vollflächig auf dem Substrat abgeschieden werden. Auch die Mehrzahl von Schichten bzw. der aktive Bereich weist eine erste Seite und eine gegenüberliegende zweite Seite auf, wobei die zweite Seite der Mehrzahl von Schichten bzw. des aktiven Bereichs auf der ersten Seite des Substrats angeordnet ist.

Im nächsten Verfahrensschritt kann zumindest eine Maskierungsschicht auf die erste Seite der Mehrzahl von Schichten abgeschieden werden. Die Maskierungsschicht kann ein Oxid oder ein Nitrid enthalten oder daraus bestehen. Beispielsweise kann die Maskierungsschicht Aluminiumoxid und/oder Siliziumoxid und/oder ein Siliziumnitrid und/oder ein Siliziumoxinitrid enthalten oder daraus bestehen. Die Maskierungsschicht kann eine Dicke von etwa 50 nm bis etwa 500 nm oder von etwa 80 nm bis etwa 125 nm aufweisen. Die Maskierungsschicht kann mittels eines PVD-Verfahrens oder mittels eines CVD-Verfahrens in an sich bekannter Weise auf die erste Seite der Mehrzahl von Schichten abgeschieden werden.

Nachfolgend kann die Maskierungsschicht photolithografisch strukturiert werden. Hierzu wird die Maskierungsschicht mit einem Fotolack bedeckt, welcher nachfolgend durch eine Maske belichtet wird. Nach Entwickeln und Entfernen des Fotolackes kann die Maskierungsschicht durch nass- oder trockenchemisches Ätzen teilweise entfernt werden, wobei die vom Fotolack bedeckten Bereiche der Maskierungsschicht auf der Oberfläche der Mehrzahl von Schichten verbleibt. Nach dem Strukturieren der Maskierungsschicht kann der Fotolack in einem weiteren Reinigungsschritt entfernt werden.

Beim einem nachfolgenden nass- oder trockenchemischen Ätzen der Mehrzahl von Schichten schützt die Maskierungsschicht das Halbleitermaterial der Mehrzahl von Schichten vor dem Angriff des Ätzmittels, sodass aus der vollflächigen oder großflächigen Beschichtung des Substrates einzelne aktive Bereiche und damit einzelne Quantenkaskadenlaser hergestellt werden können. Dabei entstehen an jedem aktiven Bereich Seitenflächen, welche jeweils die erste Seite des aktiven Bereiches mit der zweiten Seite des aktiven Bereichs verbinden.

In einigen Ausführungsformen der Erfindung kann der aktive Bereich entlang einer der Hauptachsen des kristallinen Materials des Substrates ausgerichtet werden. In einigen Ausführungsformen der Erfindung kann der aktive Bereich eine im Wesentlichen rechteckige Grundfläche auf der ersten Seite des Substrates belegen, wobei die längere Seite orthogonal zur [01̅1̅]-Richtung des Substrates verläuft. In einigen Ausführungsformen der Erfindung bedeutet dies, dass die längere Seite des aktiven Bereichs orthogonal zum "primary flat" verläuft, welcher zur Wafer-Positionierung in Produktionsanlagen dient. In einigen Ausführungsformen der Erfindung besitzt der aktive Bereich eine im Vergleich zu den Seitenflächen kleinere Stirnfläche, welche in [011]-Richtung orientiert ist.

In einigen Ausführungsformen der Erfindung wird vorgeschlagen, das Ätzen der Mehrzahl von Schichten nicht bei Erreichen der Oberfläche bzw. der ersten Seite des Substrates zu beenden, sondern auch das Substrat teilweise durch Ätzen zu entfernen. Hierdurch wird in die erste Seite des Substrates angrenzend an die zweite Seite des aktiven Bereichs eine Stufe eingebracht, wobei die Seitenfläche der Stufe mit der ersten Seite des Substrats einen Winkel von etwa 85° bis etwa 95° einschließt. In anderen Ausführungsformen der Erfindung kann die Seitenfläche der Stufe im Substrat mit der ersten Seite des Substrats einen Winkel von etwa 87° bis etwa 93° einschließen. In wiederum anderen Ausführungsformen der Erfindung kann die Seitenfläche der Stufe im Substrat mit der ersten Seite des Substrats einen Winkel von etwa 89° bis etwa 91° einschließen. In wiederum anderen Ausführungsformen der Erfindung kann die Seitenfläche der Stufe im Substrat mit der ersten Seite des Substrats einen Winkel von etwa 89,5° bis etwa 90,5° einschließen. In diesem Fall kann eine Seitenfläche der Stufe eine [011]- Orientierung aufweisen und/oder eine gegenüberliegende Seitenfläche der Stufe kann eine [011]- Orientierung aufweisen.

Das teilweise Entfernen des Substrates durch nass- oder trockenchemisches Ätzen, um angrenzend an die zweite Seite des aktiven Bereichs eine Stufe einzubringen, kann in einigen Ausführungsformen dadurch erfolgen, dass ein Teil eines homogenen Substratmaterials entfernt wird. In anderen Ausführungsformen kann das Substrat selbst beschichtet sein oder eine mehrschichtige Struktur bzw. einen mehrschichtigen Aufbau aufweisen. In diesen Fällen kann das Einbringen einer Stufe angrenzend an die zweite Seite des aktiven Bereichs dadurch erfolgen, dass zumindest eine Schicht des Substrates durch nass- oder trockenchemisches Ätzen entfernt wird. Hierbei kann eine weitere Schicht des Substrates als Ätzstoppschicht dienen.

Nachfolgend kann eine Isolatorschicht mit einer ersten Seite und einer gegenüberliegenden zweiten Seite auf der ersten Seite des Substrates und auf den Seitenflächen des aktiven Bereiches abgeschieden werden. Die Abscheidung endet, wenn die Isolatorschicht eine Dicke erreicht hat, welche bis zur ersten Seite des aktiven Bereichs bzw. der zweiten Seite der Maskierungsschicht reicht. Hierdurch wird eine Isolatorschicht erzeugt, welche dicker ist als der aktive Bereich und welche dennoch die erste Seite des aktiven Bereichs nicht bedeckt. Die Stufe im Substrat hat dabei die Wirkung, dass eine nachfolgend abgeschiedene Isolatorschicht eine unter der Maskierungsschicht verbleibende Hinterschneidung ausfüllen kann. Dadurch kann die Kristallqualität der Isolatorschicht an der Grenzfläche zum aktiven Medium verbessert sein, sodass weniger Ladungsträger aus dem aktiven Medium abfließen oder weniger Nicht-Gleichgewichtsladungsträger an tiefen Störstellen rekombinieren können.

Hierdurch kann die Ausgangsleistung des Quantenkaskadenlasers erhöht sein. Völlig überraschend wurde erkannt, dass das Einbringen einer nahezu rechtwinkligen Stufe in das Substrat angrenzend an die zweite Seite des aktiven Bereichs dazu führen kann, dass die Isolatorschicht in besserer Kristallqualität erzeugt werden kann und/oder die durch das Ätzen entstehende Hinterschneidung unter der Maskierungsschicht besser ausgefüllt werden kann und/oder eine geringere Defektdichte an der Grenzfläche zwischen der Isolatorschicht und dem aktiven Bereich ermöglichen werden kann. Diese Merkmale ermöglichen einen verbesserten Einschluss der Ladungsträger im aktiven Bereich und/oder eine längere Lebensdauer von Nicht-Gleichgewichtsladungsträgern im aktiven Bereich, sodass die Laserschwelle herabgesetzt sein kann und/oder die optische Ausgangsleistung bei gleicher Pumpleistung vergrößert sein kann.

In einigen Ausführungsformen der Erfindung kann die Isolatorschicht Indiumphosphid enthalten. In anderen Ausführungsformen der Erfindung kann die Isolatorschicht Indiumphosphid enthalten, welches mit Eisen und/oder Ruthenium dotiert ist. InP enthält oftmals unvermeidbare Verunreinigungen, welche flache Störstellen im Kristall erzeugen. Diese können bei Raumtemperatur ionisiert sein, so dass unerwünschte Nicht-Gleichgewichtsladungsträger vorhanden sind. Die Dotierung mit Eisen kann tiefe Störstellen mit Akzeptor- bzw. Donatortiefen etwa in der Mitte der Bandlückenenergie bewirken. Diese können die Rekombination von Nicht-Gleichgewichtsladungsträgern unterstützen, so dass das InP-Material praktisch keine freien Ladungsträger mehr aufweist.

Die Stufe kann in einigen Ausführungsformen der Erfindung eine Höhe zwischen etwa 0,5 pm und etwa 5 pm aufweisen. In anderen Ausführungsformen der Erfindung kann die Stufe eine Höhe zwischen etwa 1,0 pm und etwa 3 pm aufweisen. In einigen Ausführungsformen der Erfindung kann die Stufe eine Höhe aufweisen, welche zwischen etwa 20% und etwa 45% oder zwischen etwa 25% und etwa 40% oder zwischen etwa 30% und etwa 36% der Dicke des aktiven Bereichs entspricht.

In einigen Ausführungsformen der Erfindung kann das Entfernen der Mehrzahl von Schichten außerhalb der Maskierungsschicht und damit das Herstellen des aktiven Bereichs und/oder das Entfernen eines Teils der ersten Seite des Substrates unterhalb der Maskierungsschicht zumindest teilweise durch nasschemisches Ätzen in einer Ätzlösung erfolgen, welche HCl und H₃PO₄ enthält oder daraus besteht. Hierdurch kann in einigen Ausführungsformen der Erfindung eine Ätzrate von 0,8 pm/min bis 1,2 pm/min bei Raumtemperatur erzielt werden. Erfindungsgemäß wurde erkannt, dass eine solche Ätzlösung dazu führt, dass sich im Substrat mit entsprechender Kristallorientierung ohne weitere Maßnahmen eine rechtwinklige Stufe mit den genannten Eigenschaften bildet. In anderen Ausführungsformen der Erfindung kann eine rechtwinklige Stufe im Substrat durch Maskierung und trockenchemisches Ätzen hergestellt werden.

In einigen Ausführungsformen der Erfindung kann das Entfernen der Mehrzahl von Schichten außerhalb der Maskierungsschicht und damit das Herstellen des aktiven Bereichs zumindest teilweise durch Ätzen in einer Ätzlösung erfolgen, welche H₂SO₄ und H₂O₂ und H₂O enthält oder daraus besteht. In anderen Ausführungsformen der Erfindung kann das Entfernen der Mehrzahl von Schichten außerhalb der Maskierungsschicht und damit das Herstellen des aktiven Bereichs zumindest teilweise durch Ätzen in einer Ätzlösung erfolgen, welche H₃PO₄ und H₂O₂ und H₂O enthält oder daraus besteht. Auch in diesen Fällen kann das Entfernen eines Teils der ersten Seite des Substrates unterhalb der Maskierungsschicht zumindest teilweise durch Ätzen in einer Ätzlösung erfolgen, welche HCl und H₃PO₄ enthält oder daraus besteht.

Die Ätzlösung, welche HCl und H₃PO₄ enthält oder daraus besteht, kann ein Mischungsverhältnis zwischen etwa 1:1 und etwa 1:10 aufweisen, d.h. 1 Teil HCl auf 10 Teile H₃PO₄, jeweils auf das Volumen bezogen. Mit geringerem Anteil an HCl und steigendem Anteil an H₃PO₄ nimmt die Ätzrate bis auf etwa 0,1 pm/min ab, so dass die Höhe der Stufe genauer kontrollierbar sein kann.

In einigen Ausführungsformen der Erfindung kann die von der Isolatorschicht ausgefüllte Hinterschneidung unter der Maskierungsschicht in einer Richtung parallel zum Normalenvektor der Seitenflächen des aktiven Bereichs eine Ausdehnung zwischen etwa 0,5 pm und etwa 5 pm aufweisen. In anderen Ausführungsformen der Erfindung kann die von der Isolatorschicht ausgefüllte Hinterschneidung unter der Maskierungsschicht in einer Richtung parallel zum Normalenvektor der Seitenflächen des aktiven Bereichs eine Ausdehnung zwischen etwa 1 pm und etwa 5 pm aufweisen. In wiederum anderen Ausführungsformen der Erfindung kann die von der Isolatorschicht ausgefüllte Hinterschneidung unter der Maskierungsschicht in einer Richtung parallel zum Normalenvektor der Seitenflächen des aktiven Bereichs eine Ausdehnung zwischen etwa 1,5 pm und etwa 4 pm aufweisen. In wiederum anderen Ausführungsformen der Erfindung kann die von der Isolatorschicht ausgefüllte Hinterschneidung unter der Maskierungsschicht in einer Richtung parallel zum Normalenvektor der Seitenflächen des aktiven Bereichs eine Ausdehnung zwischen etwa 0,5 pm und etwa 3 pm oder zwischen etwa 1,0 pm und etwa 3 pm aufweisen. Hierdurch können Leckströme aus dem aktiven Bereich zuverlässig verhindert werden.

Nachfolgend soll die Erfindung anhand von Ausführungsbeispielen und Figuren näher erläutert werden. Dabei zeigt:
Figur 1 den Querschnitt durch ein Substrat und eine Mehrzahl von Schichten gemäß einer ersten Ausführungsform.
Figur 2 zeigt die Erzeugung des aktiven Bereichs mittels einer Maskierungsschicht gemäß der ersten Ausführungsform.
Figur 3 zeigt das Einbetten des aktiven Bereichs in eine Isolatorschicht gemäß der ersten Ausführungsform.
Figur 4 zeigt den Querschnitt durch einen erfindungsgemäßen Quantenkaskadenlaser gemäß der ersten Ausführungsform.
Figur 5 zeigt den Querschnitt durch ein Substrat und eine Mehrzahl von Schichten gemäß einer zweiten Ausführungsform.
Figur 6 zeigt die Erzeugung des aktiven Bereichs mittels einer Maskierungsschicht gemäß der zweiten Ausführungsform.
Figur 7 zeigt die Erzeugung der Stufe im Substrat gemäß der zweiten Ausführungsform.
Figur 8 zeigt das Einbetten des aktiven Bereichs in eine Isolatorschicht gemäß der zweiten Ausführungsform.
Figur 9 zeigt den Querschnitt durch einen erfindungsgemäßen Quantenkaskadenlaser gemäß der zweiten Ausführungsform.

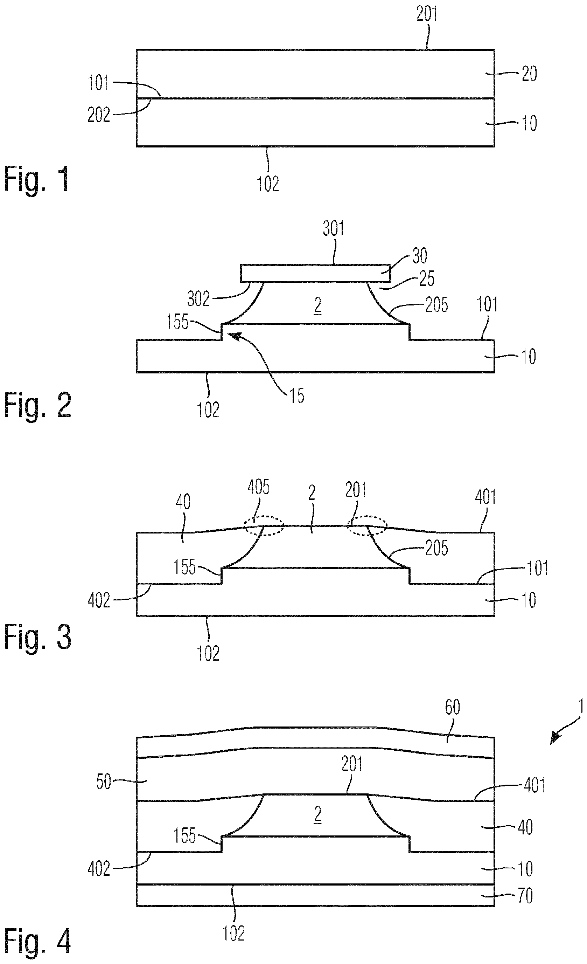

Anhand der Figuren 1 bis 4 wird die Herstellung eines erfindungsgemäßen Quantenkaskadenlasers gemäß einer ersten Ausführungsform erläutert. Wie aus Figur 1 ersichtlich ist, enthält der Quantenkaskadenlaser ein Substrat 10, welches eine erste Seite 101 und eine gegenüberliegende zweite Seite 102 aufweist. Das Substrat 10 kann beispielsweise InP enthalten oder daraus bestehen. Die erste Seite 101 kann eine [100]-Orientierung aufweisen. Das Substrat kann einkristallin sein bzw. einkristallines Material enthalten. Figur 1 zeigt das Substrat 10 vereinfachend als einzige homogene Materiallage mit einer Dicke von etwa 250 µm bis etwa 750 µm. Das Substrat 10 kann jedoch auch selbst aus einem beschichteten Träger bestehen. Beispielsweise kann eine Schicht, welche InP enthält oder daraus besteht, mit einer Schichtdicke von etwa 5 um bis etwa 100 pm oder von etwa 10 µm bis etwa 50 pm auf Saphir, Silizium, Siliziumcarbid oder einem ähnlichen Substrat angeordnet sein.

Auf die erste Seite 101 des Substrates 10 ist eine Mehrzahl 20 von Schichten aufgebracht. Die Mehrzahl 20 von Schichten kann beispielsweise zwischen etwa 10 und etwa 200 Einzelschichten oder zwischen etwa 1000 und etwa 4000 Einzelschichten oder zwischen etwa 200 und etwa 800 Einzelschichten enthalten. In anderen Ausführungsformen der Erfindung können zwischen etwa 800 und etwa 2000 Einzelschichten in der Mehrzahl 20 von Schichten enthalten sein. Jede Einzelschicht aus der Mehrzahl 20 von Schichten kann eine binäre, ternäre, quaternäre oder quinäre Verbindung eines III-V-Halbleiters enthalten oder daraus bestehen. Insbesondere kann das Element der Gruppe III ausgewählt sein aus Aluminium, Gallium und/oder Indium. Das Element der Gruppe V kann dementsprechend ausgewählt sein aus Antimon, Stickstoff, Phosphor und/oder Arsen. Die Mehrzahl 20 von Schichten kann eine Halbleiterheterostruktur bilden. Hierdurch können niedrigdimensionale Halbleiterstrukturen gebildet sein, beispielsweise Quantentöpfe, Quantendrähte oder Quantenpunkte.

Wie aus Figur 1 weiter ersichtlich ist, weist die Mehrzahl 20 von Schichten eine erste Seite 201 und eine gegenüberliegende zweite Seite 202 auf, wobei die zweite Seite 202 der Mehrzahl 20 von Schichten auf der ersten Seite 101 des Substrates 10 angeordnet ist. Die Mehrzahl 20 von Schichten kann neben den aktiven Halbleiterschichten auch zumindest eine Pufferschicht enthalten, welche beispielsweise eine Gitterfehlanpassung zum Substrat 10 ausgleichen kann. Die zumindest eine Pufferschicht kann auch als untere Zwischenschicht verwendet werden, welche modale Leckage verhindert oder reduziert. Die Erfindung lehrt nicht die Verwendung einer bestimmten Anzahl oder einer bestimmten Art von Halbleiterschichten innerhalb der Mehrzahl 20 von Schichten.

Figur 2 zeigt, wie aus der Mehrzahl 20 von Schichten ein aktiver Bereich 2 eines Quantenkaskadenlasers erhalten werden kann. Hierzu wird auf eine Teilfläche der ersten Seite 201 der Mehrzahl 20 von Schichten eine Maskierungsschicht 30 aufgebracht. Die Maskierungsschicht 30 weist wiederum eine erste Seite 301 und eine gegenüberliegende zweite Seite 302 auf. Die zweite Seite 302 der Maskierungsschicht 30 ist auf der ersten Seite 201 der Mehrzahl 20 von Schichten angebracht.

Die Maskierungsschicht 30 kann beispielsweise eine Hartmaske sein, welche ein Oxid oder ein Nitrid enthalten kann. Beispielsweise kann die Maskierungsschicht Aluminiumoxid und/oder Siliziumoxid und/oder Siliziumnitrid und/oder Siliziumoxinitrid enthalten. Die Maskierungsschicht 30 kann eine Dicke von etwa 50 nm bis etwa 500 nm oder von etwa 80 nm bis etwa 125 nm aufweisen. Die Maskierungsschicht 30 kann homogen aufgebaut sein oder eine Mehrzahl von sequenziell abgeschiedenen Einzelschichten enthalten bzw. daraus bestehen. Die Maskierungsschicht 30 kann in einigen Ausführungsformen der Erfindung selektiv auf Teilflächen der ersten Seite 201 der Mehrzahl 20 von Schichten abgeschieden sein. In anderen Ausführungsformen der Erfindung kann die Maskierungsschicht 30 vollflächig auf der ersten Seite 201 der Mehrzahl 20 von Schichten abgeschieden werden und durch nachfolgendes Maskieren mit einem Fotolack und selektivem nass- oder trockenchemischen Ätzen teilweise entfernt werden. Hierdurch kann aus der Mehrzahl 20 von Schichten zumindest ein aktiver Bereich 2 erzeugt werden. In anderen Ausführungsformen der Erfindung können mehrere aktive Bereiche 2 bzw. mehrere Quantenkaskadenlaser mit jeweils einem aktiven Bereich 2 in einem Arbeitsgang durch Strukturieren und Ätzen der Mehrzahl 20 von Schichten erzeugt werden. Der aktive Bereich kann eine im Wesentlichen rechteckige Grundfläche auf der ersten Seite des Substrates belegen, wobei die längere Seite orthogonal zur [01̅1̅]-Richtung des Substrates verläuft. In einigen Ausführungsformen der Erfindung bedeutet dies, dass die längere Seite des aktiven Bereichs orthogonal zum "primary flat" verläuft, welcher zur Wafer-Positionierung in Produktionsanlagen dient.

Durch das Strukturieren der Maskierungsschicht 30 können Teilflächen der Mehrzahl 20 von Schichten vor dem Angriff eines Ätzmittels geschützt werden. In einigen Ausführungsformen der Erfindung kann zur Herstellung des aktiven Bereichs 2 ein nasschemisches Ätzen der Mehrzahl 20 von Schichten in Schwefel- oder Phosphorsäure eingesetzt werden.

Wie Figur 2 zeigt, entstehen durch das teilweise Entfernen der Mehrzahl 20 von Schichten Seitenflächen 205, welche sich von der ersten Seite 201 des aktiven Bereichs 2 zur zweiten Seite 202 des aktiven Bereichs erstrecken. Die Seitenflächen 205 sind nicht zwingend eben. In einigen Ausführungsformen der Erfindung können die Seitenflächen 205 gekrümmt sein. In einigen Ausführungsformen der Erfindung können die Seitenflächen 205 hyperbolisch verlaufen. In einigen Ausführungsformen der Erfindung kann die Kontaktfläche des aktiven Bereichs 2 angrenzend an die Oberfläche des Substrates 10 größer sein als die Kontaktfläche des aktiven Bereichs 2 angrenzend an die Maskierungsschicht 30 nach der erfolgten Strukturierung.

Weiterhin zeigt Figur 2, dass der Flächeninhalt der zweiten Seite 202 des aktiven Bereiches 2 in etwa dem Flächeninhalt der Maskierungsschicht 30 entspricht. Demgegenüber ist der Flächeninhalt der ersten Seite 201 des aktiven Bereiches 2 geringer, da es beim nasschemischen Ätzen der Mehrzahl 20 von Schichten zu Hinterschneidungen 25 unterhalb der Maskierungsschicht 30 kommt. Eine solche Hinterschneidung kann eine Breite von etwa 500 nm bis etwa 5 pm oder von etwa 1 µm bis etwa 3 pm aufweisen.

Wie aus Figur 2 weiter ersichtlich ist, wird das Ätzen der Mehrzahl 20 von Schichten nicht beim Erreichen der ersten Seite 101 des Substrates 10 beendet. Vielmehr wird auch ein Teil des Substrates entfernt, sodass sich angrenzend an die zweite Seite 202 des aktiven Bereichs 2 eine Stufe 15 im Substrat 10 ausbildet. Diese Stufe kann in einigen Ausführungsformen der Erfindung eine Höhe zwischen etwa 0,5 pm und etwa 5 pm aufweisen. In anderen Ausführungsformen der Erfindung kann die Stufe eine Höhe zwischen etwa 1 pm und etwa 3 pm aufweisen.

Wie aus Figur 2 weiter ersichtlich ist, weist die Stufe 15 eine Form auf, bei welcher die Seitenfläche 155 der Stufe 15 mit der ersten Seite 101 des Substrats 10 einen Winkel von etwa 85° bis etwa 95° einschließt. Die Seitenfläche 155 der Stufe 15 und die erste Seite 101 stehen somit in etwa rechtwinklig aufeinander. In einigen Ausführungsformen kann eine Seitenfläche der Stufe eine [011]-orientierung aufweisen und eine gegenüberliegende Seitenfläche der Stufe kann eine [011]-Orientierung aufweisen. Die in etwa rechtwinklig verlaufende Stufe 15 kann durch selektives Ätzen hergestellt werden, wobei die orthogonal zur Zeichenebene verlaufende Längsrichtung des aktiven Bereichs 2 orthogonal zur [011]-Richtung des Substrates verläuft und zum Entfernen eines Teils des Substrates 10 eine Ätzlösung verwendet wird, welche HCl und H₃PO₄ enthält oder daraus besteht. In anderen Ausführungsformen der Erfindung kann eine rechtwinklige Stufe im Substrat durch Maskierung und trockenchemisches Ätzen hergestellt werden.

Im nächsten Verfahrensschritt, welcher in Figur 3 dargestellt ist, wird eine Isolatorschicht 40 abgeschieden. Die Isolatorschicht 40 weist wiederum eine erste Seite 401 und eine zweite Seite 402 auf, wobei die zweite Seite 402 der Isolatorschicht 40 auf der ersten Seite 101 des Substrates 10 angeordnet ist. Die Abscheidung der Isolatorschicht kann beispielsweise mittels Molekularstrahlepitaxie (MBE) mit einer Wachstumsgeschwindigkeit von etwa 1 pm/h oder durch MOCVD bzw. MOVPE bzw. HVPE mit einer Wachstumsgeschwindigkeit von etwa 1 um/h bis etwa 6 pm/h oder von etwa 2 pm/h bis etwa 6 pm/h oder von etwa 6 pm/h - etwa 10 pm/h erfolgen. Die Isolatorschicht 40 wird in einer Dicke abgeschieden, bis diese die erste Seite 201 des aktiven Bereichs 2 bzw. die zweite Seite 302 der Maskierungsschicht 30 erreicht. Erfindungsgemäß wurde erkannt, dass durch das Einbringen der Stufe 15 in das Substrat 10 die Kristallqualität an den Seitenflächen 205 verbessert werden kann und/oder ein vollständiges Wachstum der Isolatorschicht unter der Hinterschneidung 25 ermöglicht wird. Hierdurch kann die Kristallqualität der Isolatorschicht insbesondere unter der Maskierungsschicht 30 verbessert sein, sodass der solchermaßen hergestellte Quantenkaskadenlaser 1 durch geringere Leckströme eine höhere Leistungsfähigkeit aufweist.

Figur 3 zeigt weiter, dass die Maskierungsschicht 30 nach vollständiger Herstellung der Isolatorschicht 40 entfernt werden kann, beispielsweise durch nass- oder trockenchemisches Ätzen. Wie in Figur 3 darüber hinaus dargestellt ist, ist der Übergang 405 zwischen der ersten Seite 201 des aktiven Bereichs 2 und der ersten Seite 401 der Isolatorschicht vollständig oder nahezu vollständig mit dem Material der Isolatorschicht gefüllt, da das Material der Isolatorschicht 40 auch in der Hinterschneidung 25 aufwächst und diese besser als bei bekannten Herstellungsverfahren ohne Einbringen der Stufe 15 in das Substrat 10 füllt.

Figur 4 zeigt den Querschnitt durch einen erfindungsgemäßen Quantenkaskadenlaser nach dessen vollständiger Herstellung. Gegenüber dem Halbzeug gemäß Figur 3 weist der Quantenkaskadenlaser 1 einen Rückseitenkontakt 70 auf, welcher die zweite Seite 102 des Substrates 10 zumindest teilweise bedeckt. Darüber hinaus wurde die erste Seite 201 des aktiven Bereiches 2 sowie die erste Seite 401 der Isolatorschicht 40 eine Deckschicht 50 aufgebracht. Die Deckschicht 50 kann beispielsweise durch MBE oder MOCVD hergestellt sein. Die Deckschicht 50 kann InP enthalten oder daraus bestehen, welches optional mit Silizium dotiert ist.

Auf die Deckschicht 50 kann eine optionale Kontaktschicht 60 abgeschieden werden, welche beispielsweise InGaAs, welches ebenfalls mit Silizium dotiert sein kann, und/oder ein Metall oder eine Legierung enthält. Bei Betrieb des Quantenkaskadenlasers kann somit ein Betriebsstrom von der Kontaktschicht 60 durch den aktiven Bereich 2 zum Rückseitenkontakt 70 fließen, wobei das so erzeugte Laserlicht entlang der Schichtgrenzen der Mehrzahl von Schichten des aktiven Bereichs 2 emittiert wird.

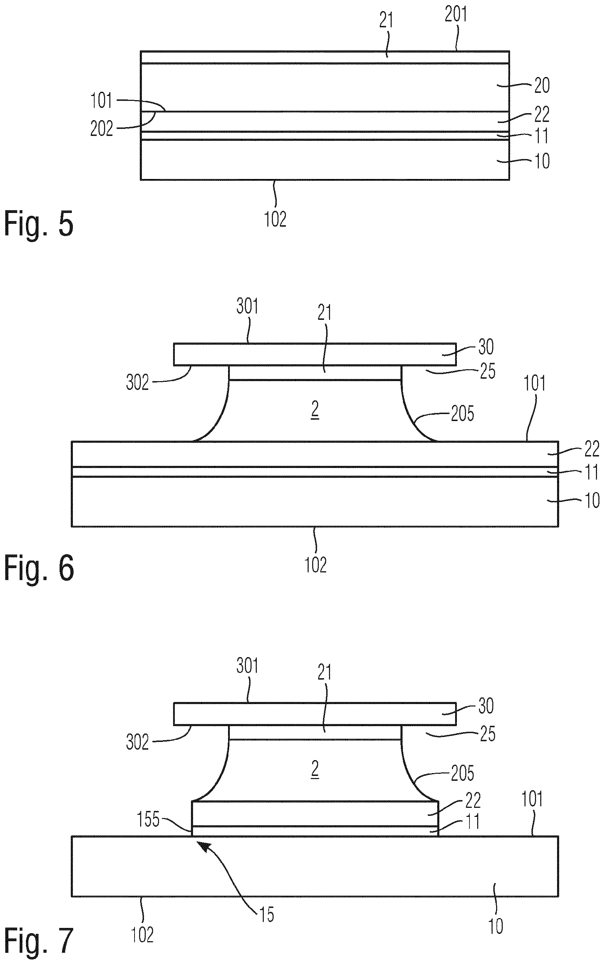

Anhand der Figuren 5 bis 9 wird ein zweites Ausführungsbeispiel der Erfindung erläutert. Gleiche Bestandteile der Erfindung sind mit gleichen Bezugszeichen versehen, so dass sich die nachstehende Beschreibung auf die wesentlichen Unterschiede beschränkt.

Wie aus Figur 5 ersichtlich ist, enthält der Quantenkaskadenlaser gemäß der zweiten Ausführungsform ebenfalls ein Substrat 10, welches eine erste Seite 101 und eine gegenüberliegende zweite Seite 102 aufweist. Das Substrat 10 kann beispielsweise InP enthalten oder daraus bestehen. Die erste Seite 101 kann eine [100]-Orientierung aufweisen.

Im Unterschied zur vorstehend beschriebenen ersten Ausführungsform enthält das Substrat 10 eine optionale Ätzstoppschicht 11, welche dazu eingerichtet und bestimmt ist, bei der späteren Fertigung des aktiven Bereichs einen Angriff des Ätzmittels auf tiefer gelegene Teile des Substrates 10 zu vermeiden. Hierdurch kann die Gleichmäßigkeit der Ätztiefe auf dem Wafer und die Reproduzierbarkeit des Prozesses von Wafer zu Wafer verbessert sein. Weiterhin enthält das Substrat eine optionale zweite Mantelschicht 22. Die Oberseite der zweiten Mantelschicht 10 bildet die erste Seite 101 des Substrates. Die zweite Mantelschicht 22 kann als Ätzstoppschicht für den aktiven Bereich 2 während der verschiedenen Schritte des Herstellungsverfahrens dienen und/oder die Gitterfehlanpassung zwischen der Ätzstoppschicht 11 und den aktiven Halbleiterschichten reduzieren. Das im zweiten Ausführungsbeispiel verwendete Substrat weist somit einen mehrschichtigen Aufbau auf.

Die Ätzstoppschicht kann eine arsenidhaltige Schicht enthalten oder daraus bestehen. Beispielsweise kann die Ätzstoppschicht InAs und/oder InGaAs und/oder InGaAsP enthalten oder daraus bestehen. Die Ätzstoppschicht kann eine Dicke von etwa 5 nm bis etwa 200 nm oder von etwa 10 nm bis etwa 50 nm aufweisen. Die Ätzschicht kann direkt auf der ersten Seite 101 des Substrats abgeschieden werden.

Auf der ersten Seite 101 des Substrates 10 ist eine Mehrzahl 20 von Schichten aufgebracht, wie vorstehend anhand der Figur 1 erläutert. Auch in der zweiten Ausführungsform kann die Mehrzahl 20 von Halbleiterschichten niedrigdimensionale Halbleiterstrukturen bilden, beispielsweise Quantentöpfe, Quantendrähte oder Quantenpunkte.

Wie aus Figur 5 weiter ersichtlich ist, weist die Mehrzahl 20 von Schichten eine erste Seite 201 und eine gegenüberliegende zweite Seite 202 auf, wobei die zweite Seite 202 der Mehrzahl 20 von Schichten auf der ersten Seite 101 des Substrates 10 angeordnet ist.

Im Unterschied zur vorstehend beschriebenen ersten Ausführungsform enthält die Mehrzahl 20 von Schichten neben den aktiven Halbleiterschichten auch eine optionale obere Mantelschicht 21. Die auf der Mehrzahl aktiver Halbleiterschichten 20 aufgewachsene obere Mantelschicht 21 dient als Schutzschicht für den aktiven Bereich 2 während der verschiedenen Schritte des Herstellungsverfahrens. Weiterhin kann die obere Mantelschicht 21 die Herstellung der Deckschicht 50 erleichtern, wenn diese ein homoepitaktisches Wachstum der Deckschicht 50 ermöglicht.

Zwischen der ersten Seite 101 des Substrates 10 bzw. zwischen der Ätzstoppschicht 11 einerseits und der Mehrzahl 20 von aktiven Halbleiterschichten kann sich eine optionale zweite Mantelschicht 22 befinden. Diese kann als Ätzstoppschicht für den aktiven Bereich 2 während der verschiedenen Schritte des Herstellungsverfahrens dienen und/oder die Gitterfehlanpassung zwischen dem Substrat 10 bzw. der Ätzstoppschicht 11 und den aktiven Halbleiterschichten reduzieren.

Die Mantelschichten 21 und 22 können InP enthalten oder daraus bestehen. Die erste Mantelschicht 21 kann eine Dicke von etwa 10 nm bis etwa 500 nm oder von etwa 20 nm bis etwa 200 nm aufweisen. Die zweite Mantelschicht 22 kann eine Dicke von etwa 0,5 um bis etwa 10 pm oder von etwa 10 nm bis etwa 2000 nm oder von etwa 0,5 µm bis etwa 5 pm oder von etwa 1 µm bis etwa 3 pm aufweisen.

Figur 6 zeigt, wie aus der Mehrzahl 20 von Schichten ein aktiver Bereich 2 eines Quantenkaskadenlasers erhalten werden kann. Hierzu wird auf eine Teilfläche der ersten Seite 201 der Mehrzahl 20 von Schichten bzw. auf die obere Mantelschicht 21 eine Maskierungsschicht 30 aufgebracht. Die Maskierungsschicht 30 weist wiederum eine erste Seite 301 und eine gegenüberliegende zweite Seite 302 auf. Die zweite Seite 302 der Maskierungsschicht 30 ist auf die erste Seite 201 der Mehrzahl 20 von Schichten aufgebracht. Wie vorstehend in Zusammenhang mit dem ersten Ausführungsbeispiel ausgeführt, kann die Maskierungsschicht 30 beispielsweise eine Hartmaske sein, welche ein Oxid oder ein Nitrid enthalten kann.

Wie Figur 6 zeigt, entstehen durch das teilweise Entfernen der Mehrzahl 20 von Schichten Seitenflächen 205, welche sich von der ersten Seite 201 des aktiven Bereichs 2 zur zweiten Seite 202 des aktiven Bereichs erstrecken. Weiterhin zeigt Figur 6, dass der Flächeninhalt der zweiten Seite 202 des aktiven Bereiches 2 in etwa dem Flächeninhalt der Maskierungsschicht 30 entspricht. Demgegenüber ist der Flächeninhalt der ersten Seite 201 des aktiven Bereiches 2 geringer, da es beim nasschemischen Ätzen der Mehrzahl 20 von Schichten zu Hinterschneidungen 25 unterhalb der Maskierungsschicht 30 kommt. Eine solche Hinterschneidung kann eine Breite von etwa 500 nm bis etwa 5 pm oder von etwa 1 um bis etwa 3 pm aufweisen.

Wie aus Figur 6 weiter ersichtlich ist, wird das Ätzen der Mehrzahl 20 von Schichten beim Erreichen der zweiten Mantelschicht 22 beendet. Dies kann in einigen Ausführungsformen der Erfindung zuverlässig erfolgen, wenn ein Ätzmittel verwendet wird, welches das Material der zweiten Mantelschicht 22 nicht angreift. Die zweite Mantelschicht 22 wirkt in diesem Fall als Ätzstoppschicht.

Mit Verweis auf Figur 7 wird die Herstellung der Stufe 15 näher erläutert. Hierzu wird ein Teil der zweiten Mantelschicht 22 und optional ein Teil der Ätzstoppschicht 11 des Substrates 10 entfernt, sodass sich angrenzend an die zweite Seite 202 des aktiven Bereichs 2 eine Stufe 15 mit einer Seitenfläche 155 im Substrat 10 ausbildet. Die Höhe der Stufe kann in diesem Fall der Dicke der zweiten Mantelschicht 22 entsprechen. In anderen Ausführungsformen der Erfindung kann die Höhe der Stufe der Summe der Dicken der zweiten Mantelschicht 22 und der Ätzstoppschicht 11 entsprechen Hierzu kann ein Ätzmittel verwendet werden, welches das Material der zweiten Mantelschicht 22 und der Ätzstoppschicht 11 mit hoher Ätzrate angreift, das Material des Substrates 10 aber nicht oder mit geringerer Ätzrate angreift, so dass die Lage der zweiten Seite 102 und die Höhe der Stufe 15 am fertigen Bauelement mit hoher Genauigkeit kontrolliert werden kann. Alternativ kann ein Ätzmittel verwendet werden, welches das Material der zweiten Mantelschicht 22 mit hoher Ätzrate angreift, das Material der Ätzstoppschicht 11 aber nicht oder mit geringerer Ätzrate angreift.

In einigen Ausführungsformen der Erfindung kann hierzu ein zweistufiges Ätzverfahren eingesetzt werden, bei welchem in einem ersten Schritt die zweite Mantelschicht 22 (InP) selektiv in H₃PO₄ und HCl geätzt wird. Anschließend wird die Ätzstoppschicht 11 (InGaAs) selektiv in H₃PO₄:H₂O₂:H₂O oder H₂SO₄:H₂O₂:H₂O geätzt.

Wie aus Figur 7 weiter ersichtlich ist, weist die Stufe 15 eine Form auf, bei welcher die Seitenfläche 155 der Stufe 15 mit der ersten Seite 101 des Substrats 10 einen Winkel von etwa 85° bis etwa 95° einschließt. Die Seitenfläche 155 der Stufe 15 und die erste Seite 101 stehen somit in etwa rechtwinklig aufeinander. Hierdurch kann eine Seitenfläche 155 der Stufe 15 eine [01̅1]-Orientierung aufweisen und eine gegenüberliegende Seitenfläche 155 der Stufe 15 kann eine [011̅]-Orientierung aufweisen. Dies kann durch selektives Ätzen erreicht werden, wenn der aktive Bereich eine im Wesentlichen rechteckige Grundfläche auf der ersten Seite des Substrates belegt, wobei die längere Seite orthogonal zur [01̅1̅]-Richtung des Substrates verläuft. In einigen Ausführungsformen der Erfindung bedeutet dies, dass die längere Seite des aktiven Bereichs orthogonal zum "primary flat" verläuft, welcher zur Wafer-Positionierung in Produktionsanlagen dient. Darüber hinaus kann zum Entfernen der freiliegenden Teile der zweiten Mantelschicht 22 und der Ätzstoppschicht 11 beispielsweise eine Ätzlösung verwendet werden, welche HCl und H₃PO₄ enthält oder daraus besteht.

In einigen Ausführungsformen der Erfindung kann hierzu ein zweistufiges Ätzverfahren eingesetzt werden, bei welchem in einem ersten Schritt die zweite Mantelschicht 22 (InP) selektiv in H₃PO₄ und HCl geätzt wird. Anschließend wird die Ätzstoppschicht 11 (InGaAs) selektiv in H₃PO₄:H₂O₂:H₂O oder H₂SO₄:H₂O₂:H₂O geätzt.

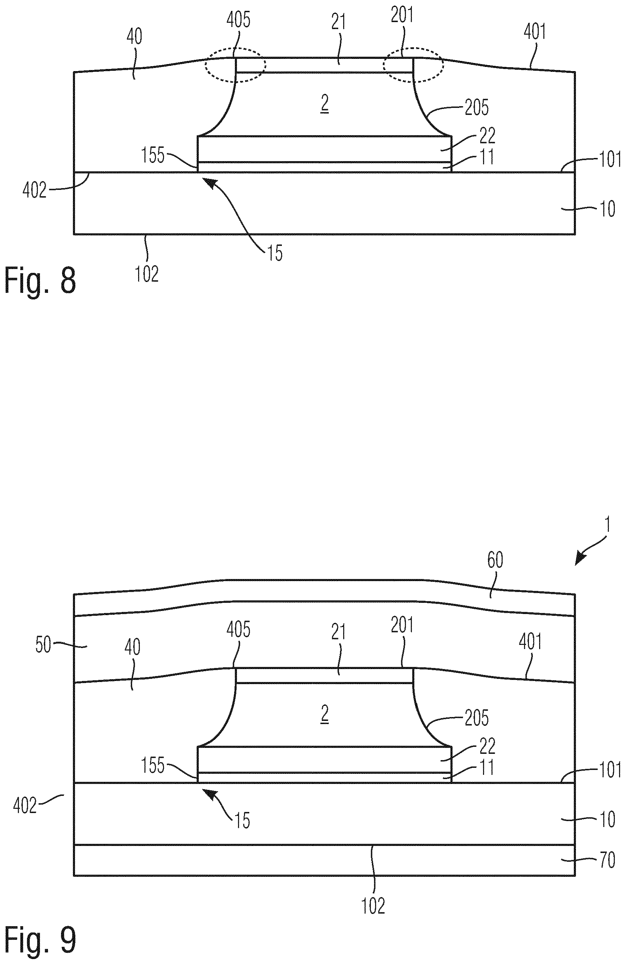

Im nächsten Verfahrensschritt, welcher in Figur 8 dargestellt ist, wird eine Isolatorschicht 40 abgeschieden. Die Isolatorschicht 40 weist wiederum eine erste Seite 401 und eine gegenüberliegende zweite Seite 402 auf, wobei die zweite Seite 402 der Isolatorschicht 40 auf der ersten Seite 101 des Substrates 10 angeordnet ist. Die Abscheidung der Isolatorschicht kann beispielsweise mittels Molekularstrahlepitaxie (MBE) mit einer Wachstumsgeschwindigkeit von etwa 1 µm/h oder durch MOCVD bzw. MOVPE mit einer Wachstumsgeschwindigkeit von etwa 1 µm/h bis etwa 6 µm/h oder von etwa 6 µm/h bis etwa 10 µm/h erfolgen. Die Isolatorschicht 40 wird in einer Dicke abgeschieden, bis diese die erste Seite 201 des aktiven Bereichs 2 bzw. die zweite Seite 302 der Maskierungsschicht 30 erreicht.

Erfindungsgemäß wurde erkannt, dass durch das Einbringen der Stufe 15 in das Substrat 10 die Kristallqualität an den Seitenflächen 205 verbessert werden kann und/oder ein vollständiges Wachstum der Isolatorschicht unter der Hinterschneidung 25 ermöglicht wird. Hierdurch kann die Kristallqualität und/oder die Pfadlänge der Isolatorschicht insbesondere unter der Maskierungsschicht 30 verbessert sein, sodass der solchermaßen hergestellte Quantenkaskadenlaser 1 durch geringere Leckströme eine höhere Leistungsfähigkeit aufweist.

Figur 8 zeigt weiter, dass die Maskierungsschicht 30 nach vollständiger Herstellung der Isolatorschicht 40 entfernt werden kann, beispielsweise durch nass- oder trockenchemisches Ätzen. Wie in Figur 8 darüber hinaus dargestellt ist, ist der Übergang 405 zwischen der ersten Seite 201 des aktiven Bereichs 2 und der ersten Seite 401 der Isolatorschicht vollständig oder nahezu vollständig mit dem Material der Isolatorschicht gefüllt, da das Material der Isolatorschicht 40 auch in der Hinterschneidung 25 aufwächst und diese besser als bei bekannten Herstellungsverfahren ohne Einbringen der Stufe 15 in das Substrat 10 füllt.

Figur 9 zeigt den Querschnitt durch einen erfindungsgemäßen Quantenkaskadenlaser nach dessen vollständiger Herstellung. Gegenüber dem Halbzeug gemäß Figur 8 weist der Quantenkaskadenlaser 1 einen Rückseitenkontakt 70 auf, welcher die zweite Seite 102 des Substrates 10 zumindest teilweise bedeckt. Darüber hinaus wurde auf die erste Seite 201 des aktiven Bereiches 2 sowie die erste Seite 401 der Isolatorschicht 40 eine Deckschicht 50 aufgebracht. Die Deckschicht 50 kann beispielsweise durch MBE oder MOCVD hergestellt sein. Die Deckschicht 50 kann InP enthalten oder daraus bestehen, welches optional mit Silizium dotiert ist.

Auf die Deckschicht 50 kann eine optionale Kontaktschicht 60 abgeschieden werden, welche beispielsweise InGaAs und/oder ein Metall oder eine Legierung enthält, welches ebenfalls mit Silizium dotiert sein kann. Bei Betrieb des Quantenkaskadenlasers kann somit ein Betriebsstrom von der Kontaktschicht 60 durch den aktiven Bereich 2 zum Rückseitenkontakt 70 fließen, wobei das so erzeugte Laserlicht entlang der Schichtgrenzen der Mehrzahl von Schichten des aktiven Bereichs 2 emittiert wird.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Quantenkaskadenlaser (1)
mit einem Substrat (10) mit einer ersten Seite (101) und einer gegenüberliegenden zweiten Seite (102) und
mit einem aktiven Bereich (2) mit einer ersten Seite (201) und einer gegenüberliegenden zweiten Seite (202), wobei die zweite Seite (202) des aktiven Bereichs (2) auf der ersten Seite (101) des Substrats (10) angeordnet ist und der aktive Bereich (2) Seitenflächen (205) aufweist, welche sich von der ersten Seite (201) des aktiven Bereichs (2) zur zweiten Seite (202) des aktiven Bereichs (2) erstrecken und
mit zumindest einer Isolatorschicht (40) mit einer ersten Seite (401) und einer gegenüberliegenden zweiten Seite (402), wobei die zweite Seite (402) der Isolatorschicht (40) auf der ersten Seite (101) des Substrats (10) angeordnet ist und sich die Isolatorschicht (40) bis zu den Seitenflächen (205) des aktiven Bereichs (2) erstreckt und dicker ist als der aktive Bereich (2) und die erste Seite (201) des aktiven Bereichs (2) nicht bedeckt
**dadurch gekennzeichnet, dass**
in die erste Seite (101) des Substrats (10) angrenzend an die zweite Seite (202) des aktiven Bereichs (2) eine Stufe (15) eingebracht ist, wobei die Seitenfläche (155) der Stufe (15) mit der ersten Seite (101) des Substrats (10) einen Winkel von 85° bis 95° einschließt und
eine Seitenfläche (155) der Stufe (15) eine [011]-Orientierung aufweist und/oder eine Seitenfläche (155) der Stufe (15) eine [011]- Orientierung aufweist.

2. Quantenkaskadenlaser nach Anspruch 1, **dadurch gekennzeichnet, dass** das Substrat (10) GaAs und/oder GaN und/oder AlN und/oder InP und/oder Si und/oder SiC und/oder Saphir enthält oder daraus besteht und/oder der aktive Bereich (2) eine Abfolge von Schichten enthält, welche jewweils entweder InAlAs oder InGaAs oder welche jeweils entweder AlAs oder InAs enthalten oder daraus bestehen und/oder
das die Isolatorschicht (40) Indiumphosphid (InP) enthält oder daraus besteht, welches optional mit Eisen und/oder Ruthenium dotiert sein kann.

3. Quantenkaskadenlaser nach Anspruch 1 oder 2, **dadurch gekennzeichnet, dass** die Seitenfläche (155) der Stufe (15) mit der ersten Seite (101) des Substrats (10) einen Winkel von 87° bis 93° oder von 89° bis 91° oder von 89,5° bis 90,5° einschließt.

4. Quantenkaskadenlaser nach einem der Ansprüche 1 bis 3, **dadurch gekennzeichnet, dass** die Stufe (15) eine Höhe zwischen etwa 0,5 pm und etwa 5 pm oder zwischen etwa 1,0 pm und etwa 3 pm aufweist und/oder
dass die Stufe (15) eine Höhe aufweist, welche zwischen 20% und 45% oder zwischen 25% und 40% oder zwischen 30% und 36% der Dicke des aktiven Bereichs (2) entspricht.

5. Verfahren zur Herstellung eines Quantenkaskadenlasers (1) mit folgenden Schritten:
Bereitstellen eines Substrates (10) mit einer ersten Seite (101) und einer gegenüberliegenden zweiten Seite (102) ;
Abscheiden einer Mehrzahl von Schichten (20) aus zumindest einem Halbleitermaterial auf der ersten Seite (101) des Substrates (10), welche dazu vorgesehen sind, einen aktiven Bereich (2) mit einer ersten Seite (201) und einer gegenüberliegenden zweiten Seite (202) zu bilden;
Abscheiden von zumindest einer Maskierungsschicht (30) auf die erste Seite (201) der Mehrzahl von Schichten (20) ;
Entfernen der Maskierungsschicht (30) außerhalb der Stellen, an welchen kein aktiver Bereich (2) erzeugt werden soll;
Entfernen der Mehrzahl von Schichten (20) außerhalb der Maskierungsschicht (30) durch Ätzen;
Entfernen eines Teils der ersten Seite (101) des Substrates (10) unterhalb der Maskierungsschicht (30) durch Ätzen, sodass in die erste Seite (101) des Substrats (10) angrenzend an die zweite Seite (202) des aktiven Bereichs (2) eine Stufe (15) eingebracht ist, wobei die Seitenfläche (155) der Stufe (15) mit der ersten Seite (101) des Substrats (10) einen Winkel von 85° bis 95° einschließt, wobei
eine Seitenfläche (155) der Stufe (15) mit einer [011]-Orientierung erzeugt wird und/oder eine Seitenfläche (155) der Stufe (15) mit einer [011]- Orientierung erzeugt wird;
Abscheiden von zumindest einer Isolatorschicht (40) mit einer ersten Seite (401) und einer gegenüberliegenden zweiten Seite (402) auf der ersten Seite (101) des Substrats (10) und auf den Seitenflächen (205) des aktiven Bereichs (2), bis eine Dicke erreicht ist, welche bis zur zweiten Seite (302) der Maskierungsschicht (30) reicht;
Entfernen der Maskierungsschicht (30).

6. Verfahren nach Anspruch 5, **dadurch gekennzeichnet, dass** dass das Substrat (10) GaAs und/oder GaN und/oder AlN und/oder InP und/oder Si und/oder SiC und/oder Saphir enthält oder daraus besteht und/oder
dass Einzelschichten aus der Mehrzahl von Schichten (20) entweder InAlAs oder InGaAs enthalten oder daraus bestehen und/oder
das die Isolatorschicht (40) InP enthält oder daraus besteht, welches optional mit Eisen und/oder Ruthenium dotiert ist.

7. Verfahren nach einem der Ansprüche 5 oder 6, **dadurch gekennzeichnet, dass** die Isolatorschicht (40) und/oder die Mehrzahl von Schichten (20) mittels MBE oder MOCVD hergestellt wird.

8. Verfahren nach einem der Ansprüche 5 bis 7, **dadurch gekennzeichnet, dass** das Ätzen der ersten Seite (101) des Substrates (10) bis in eine Tiefe von etwa 0,5 pm und etwa 5 pm oder zwischen etwa 1,0 pm und etwa 3 pm erfolgt und/oder
dass das Ätzen der ersten Seite (101) des Substrates (10) bis in eine Tiefe erfolgt, welche zwischen 20% und 45% oder zwischen 25% und 40% oder zwischen 30% und 36% der Dicke der Mehrzahl von Schichten (20) entspricht und/oder
dass das Ätzen der ersten Seite (101) des Substrates (10) bis in eine Tiefe erfolgt, welche durch eine im Substrat (10) eingebettete Ätzstoppschicht (11) definiert ist.

9. Verfahren nach einem der Ansprüche 5 bis 8, **dadurch gekennzeichnet, dass** die Maskierungschicht (30) ein Oxid und/oder ein Nitrid enthält oder daraus besteht.

10. Verfahren nach einem der Ansprüche 5 bis 9, **dadurch gekennzeichnet, dass** die Seitenfläche (155) der Stufe (15) im Substrat (10) mit der ersten Seite (101) des Substrats (10) einen Winkel von 87° bis 93° oder von 89° bis 91° oder von 89,5° bis 90,5° einschließt.

11. Verfahren nach einem der Ansprüche 5 bis 10, **dadurch gekennzeichnet, dass** das Entfernen der Mehrzahl von Schichten (20) außerhalb der Maskierungsschicht (30) und/oder das Entfernen eines Teils der ersten Seite (101) des Substrates (10) unterhalb der Maskierungsschicht (30) durch Ätzen in einer Ätzlösung erfolgt, welche HCl und H₃PO₄ enthält oder daraus besteht.

12. Verfahren nach einem der Ansprüche 5 bis 11, **dadurch gekennzeichnet, dass** das Entfernen der Mehrzahl von Schichten (20) außerhalb der Maskierungsschicht (30) zumindest teilweise durch Ätzen in einer Ätzlösung erfolgt,
welche H₂SO₄ und H₂O₂ und H₂O enthält oder daraus besteht oder
welche H₃PO₄ und H₂O₂ und H₂O enthält oder daraus besteht und das nachfolgende Entfernen eines Teils der ersten Seite des Substrates unterhalb der Maskierungsschicht zumindest teilweise durch Ätzen in einer Ätzlösung erfolgen, welche HCl und H₃PO₄ enthält oder daraus besteht.

13. Verfahren nach einem der Ansprüche 5 bis 12, **dadurch gekennzeichnet, dass** das Entfernen der Mehrzahl von Schichten (20) außerhalb der Maskierungsschicht (30) und/oder das Entfernen eines Teils der ersten Seite (101) des Substrates (10) unterhalb der Maskierungsschicht (30) durch Ätzen mit einer Ätzrate von 0,8 pm/min bis 1,2 µm/min bei Raumtemperatur erfolgt.

14. Verfahren nach einem der Ansprüche 5 bis 13, **dadurch gekennzeichnet, dass** die erste Seite (201) des aktiven Bereichs (2) einen geringeren Flächeninhalt aufweist als die gegenüberliegende zweite Seite (202), so dass sich zwischen dem aktiven Bereich (2) und der Maskierungsschicht (30) eine Hinterschneidung (25) ausbildet und die Isolatorschicht (40) die Hinterschneidung (25) ausfüllt.

15. Verfahren nach Anspruch 14, **dadurch gekennzeichnet, dass** die von der Isolatorschicht (40) ausgefüllte Hinterschneidung (25) in einer Richtung parallel zum Normalenvektor der Seitenflächen (205) des aktiven Bereichs (2) eine Ausdehnung zwischen 0,5 pm und 5 pm oder zwischen 1 pm und 5 pm oder zwischen 1,5 pm und 4 µm oder zwischen 1,0 pm und 3 pm aufweist.
